# EUROPEAN PATENT SPECIFICATION

(11) **EP 3 221 497 B1**
(45) Date of publication and mention of the grant of the patent: **26.09.2018**
(21) Application number: 16774695.7
(22) Date of filing: 30.09.2016
(51) Int. Cl.: C25D 17/00, C25D 5/08, H05K 3/24

(54) **GALVANIC PLATING DEVICE OF A HORIZONTAL GALVANIC PLATING PROCESSING LINE FOR GALVANIC METAL DEPOSITION AND USE THEREOF**
GALVANISIERUNGSVORRICHTUNG EINER HORIZONTALEN GALVANISIERUNGSVERARBEITUNGSSTRASSE ZUR GALVANISCHEN METALLABSCHEIDUNG UND DESSEN VERWENDUNG
DISPOSITIF DE DÉPÔT GALVANIQUE D'UNE LIGNE DE TRAITEMENT DE DÉPÔT GALVANIQUE HORIZONTAL POUR UN DÉPÔT ÉLECTROLYTIQUE ET SON UTILISATION

(30) Priority: 28.10.2015 EP 15191923
(43) Date of publication of application: 27.09.2017
(73) Proprietor: Atotech Deutschland GmbH, 10553 Berlin (DE)
(72) Inventor: WIENER, Ferdinand, 10553 Berlin (DE); MÖRLEIN, Felix, 10553 Berlin (DE)
(86) International application number: PCT/EP2016/073454
(87) International publication number: WO 2017/071908

(56) References cited:
- DE-A1-102009 004 249
- DE-A1-102009 023 765
- US-A1- 2007 114 125
- US-B1- 6 238 529

## Description

### Field of the Invention

The present invention relates to a galvanic plating device of a horizontal galvanic plating processing line for galvanic metal, in particular copper, deposition; wherein said galvanic plating device comprises at least a first galvanic plating module, which is arranged below a transport level of a substrate to be treated, and at least a plating clamp arranged on a first side of the galvanic plating device; wherein said first galvanic plating module comprises at least an electrolyte nozzle and at least an anode element inside of said galvanic plating module.

The present invention is further directed to the use of such a galvanic plating device for galvanic metal, preferably copper, deposition on printed circuit foils, flexible printed circuit boards and embedded chip substrates.

### Background of the Invention

The industry has already making use of horizontal galvanic (means with the application of current) process lines for metal, commonly copper, tin or nickel, deposition on a substrate to be treated since many decades.

In the past, the substrates to be treated have been relatively thick, stiff and heavy compared to the presence. In our days, the market requires more and more in consequence of the on-going worldwide technical miniaturization in the printed circuit board area devices and process lines, which can also safely treat substrates to be treated, which are much thinner than anything, which has been processed up to now. At the same time as a consequence of reduced thickness, the weight of each individual substrate to be treated is largely reduced while the flexibility of the substrate to be treated is largely increased.

This leads to entirely new technical challenges in transporting and treating of substrates to be treated. Market demands for substrates having a thickness down to 25 micrometer generate the severe problem of safely transporting said thin flexible substrates without that they are getting damaged by crumpling or undesired running between individual transport rollers or wheel axis below or above the transport level of the transport or process line.

Document US 6,238,529 B1 discloses an apparatus for electrolytically treating printed circuit boards and conductor foils using an electrolytic fluid, through which apparatus the printed circuit boards or conductor foils are continuously guidable in a plane of conveyance in a substantially horizontal direction of conveyance. Herein, said apparatus comprises a plurality of counter-electrodes disposed opposite the plane of conveyance and substantially parallel thereto on at least one side, so that electrolytic chambers are formed between counter-electrodes, which are situated opposite one another, or between the counter-electrodes and the plane of conveyance, the counter-electrodes forming respective substantially continuous electrode faces. The apparatus comprises further guide elements for the printed circuit boards and conductor foils disposed in the electrolytic chamber; contact elements provided for the electrical contacting of the printed circuit boards and conductor foils; and electrolyte spraying arrangements provided for conveying the electrolytic fluid towards the surfaces of the printed circuit boards and conductor foils. Herein, openings are provided in the plurality of counter-electrodes, and the electrolyte spraying arrangements are disposed on the sides of the counter-electrodes remote from the plane of conveyance are adapted for passing electrolytic fluid there through to the surfaces of the printed circuit board or conductor foils, said passing providing a flow of the electrolyte past the counter electrodes substantially unhindered at the location of the openings; and wherein the plurality of counter electrodes are isolated from one another by means of spacer strips and/or seals.

Attempts to avoid such misleading of flexible materials have been attempted in the past, wherein the main approach has been to fix each substrate to be treated at both sides by clips, hooks or clamps.

However, it is often difficult to safely run such a substrate through the entire process line, even when at the beginning the substrate is completely stretched. One problem arising with this approach represents the bending of the substrates after a certain period of time during still processing the substrate through the process line. This leads to undesired qualitative metal deposition results and distributions. In the worst case, the bending effect is so strong that the substrate is getting crumpled between individual transport elements.

### Objective of the present Invention

In view of the prior art, it was thus an object of the present invention to provide a device, which is able to avoid any damaging of thin substrates to be treated during processing and to ensure a safe transport.

In particular, it was an object of the present invention to provide a device, which can avoid that thin flexible substrates can run between individual transport elements, which are commonly arranged above and below of the transport level of the process line.

Additionally, it was especially an object of the present invention to provide a device, which can avoid that such flexible thin substrates to be treated will flow upwards or downwards during passing a horizontal galvanic processing line, even when no traditional common transport elements, such as wheel axis or rollers, will be used.

Additionally, it was an object to provide a device, which can be modified in already existing process lines without any large effort or cost.

### Summary of the Invention

These objects and also further objects which are not stated explicitly but are immediately derivable or discernible from the connections discussed herein by way of introduction are achieved by a galvanic plating device having all features of claim 1. Appropriate modifications to the inventive device are protected in dependent claims 2 to 14. Further, claim 15 relates to the use of such an inventive device for galvanic metal, preferably copper, deposition on printed circuit foils, flexible printed circuit boards and embedded chip substrates.

The present invention accordingly provides a galvanic plating device of a horizontal galvanic plating processing line for galvanic metal, in particular copper, deposition; wherein said galvanic plating device comprises at least a first galvanic plating module, which is arranged below a transport level of a substrate to be treated, and at least a plating clamp arranged on a first side of the galvanic plating device; wherein said first galvanic plating module comprises at least an electrolyte nozzle and at least an anode element inside of said galvanic plating module, wherein said galvanic plating module further comprises at least a covering plate having a plurality of openings arranged above the anode element and the electrolyte nozzle; wherein the galvanic plating device further comprises at least a substrate guiding element arranged on the surface of the covering plate of the galvanic plating module, wherein said substrate guiding element is in conjunction with said surface of the covering plate of the galvanic plating module.

It is thus possible in an unforeseeable manner to provide a galvanic plating device, which is able to avoid any damaging of thin substrates to be treated during processing and which ensures a safe transport.

In addition thereto, the inventive galvanic plating device avoids that thin flexible substrates run between individual transport elements, which are commonly arranged above and below of the transport level of the process line, and which are absent in this device due to the sole application of at least a clamp as transport element.

Furthermore, the inventive galvanic plating device avoids that such flexible thin substrates to be treated will flow upwards or downwards during passing the horizontal galvanic processing line, even when no traditional common transport elements, such as wheel axis or rollers, are used.

Additionally, the inventive device can be easily installed in already existing process lines without any large effort or cost.

### Brief Description of the Figures

For a more complete understanding of the present invention, reference is made to the following Detailed Description of the Invention considered in conjunction with the accompanying figures, in which:
Fig. 1 shows a schematic perspective side view of a first galvanic plating module of an inventive galvanic plating device in accordance with an embodiment of the present invention.
Fig. 2 shows an enlarged schematic perspective side view on the entry side of a first galvanic plating module of an inventive galvanic plating device in accordance with the embodiment of the present invention shown in Figure 1.
Fig. 3 shows an enlarged schematic perspective side view on the exit side of a first galvanic plating module of an inventive galvanic plating device in accordance with the embodiment of the present invention shown in Figure 1.
Fig. 4 shows a schematic front view of an individual substrate guiding element having a dove tail profile being used in a first galvanic plating module of an inventive galvanic plating device in accordance with the embodiment of the present invention shown in Figure 1.
Fig. 5 shows a schematic perspective side view of a first and an adjacent third galvanic plating module of an inventive galvanic plating device in accordance with the embodiment of the present invention shown in Figure 1.
Fig. 6 shows a schematic perspective front view of a first and an adjacent third galvanic plating module of an inventive galvanic plating device in accordance with the embodiment of the present invention shown in Figure 1.
Fig. 7a shows a schematic perspective side view of a substrate guiding element used in a preferred embodiment of the present invention.
Fig. 7b shows a schematic top view of a substrate guiding element used in the preferred embodiment of the present invention shown in Figure 7a.
Fig. 8a shows a schematic perspective sectional side view of a substrate guiding element used in the preferred embodiment of the present invention shown in Figure 7a.
Fig. 8b shows another schematic perspective sectional side view of a substrate guiding element used in the preferred embodiment of the present invention shown in Figure 7a.

### Detailed Description of the Invention

As used herein, the term "galvanic plating device" refers to a device, which is required to conduct a galvanic process, which is intended to deposit the desired galvanic metal, such as copper, tin, gold, silver or alike, on the surface of a substrate to be treated. That means that such a galvanic plating device represents the "core" unit of a horizontal galvanic plating processing line for galvanic metal, in particular copper, deposition. There are a certain number of pretreatment and post treatment steps arranged before and after said galvanic plating device, such as rinsing, drying, etching and alike. However, the main or core step remain the galvanic plating process step itself, which has to be executed in said improved inventive galvanic plating device of the present invention.

As used herein, the term "galvanic plating module" refers to a device element or to a subunit of the galvanic plating device, which is arranged below and/or above the transport level of a substrate to be treated. It has been already shown in conventional horizontal processing lines that it is advantageous to establish such an entire line as a modular system. This facilitates service and maintenance issues due to an easier access to the individual device elements or subunits of the horizontal processing line.

Thus, the inventive galvanic plating device can comprise a plurality of such subunits in form of said galvanic plating modules, which are exclusively arranged below the transport level, if only an one side galvanic plating process is desired, or on both sides of the transport level, if a both side galvanic plating process is desired.

Each of these subunits in form of galvanic plating modules comprises at least one electrolyte nozzle for providing electrolyte flow towards the surface of the substrate to be treated in order to conduct galvanic plating. Very often it is not only one electrolyte nozzle, but a plurality of individual electrolyte nozzles in order to improve the uniformity of the galvanic metal deposit on the surface of the substrate to be treated by increasing the material exchange of the electrolyte on said surface.

Each of these subunits in form of galvanic plating modules comprises further at least an anode element for providing the required electrical field for the galvanic plating process step.

Each of these subunits in form of galvanic plating modules comprises further at least a covering plate having a plurality of openings arranged above the anode element and the electrolyte nozzle. In theory, it would be ideal, if said covering is removed entirely. Such a covering plate hampers the electrical field and the electrolyte flow. Therefore, it is attempted to provide the covering plate with a maximum of openings in order to reduce the negative effect on the electrical field and the electrolyte flow as much as possible. However, the customers insist on the application of these covering plates because nobody would like to risk electrical short-circuits caused by substrates to be treated, which unintentionally flow down during processing in the galvanic plating device until they reach the anode element(s) itself(s). Thus, it has been common to make use of these covering plates having a maximum of openings in the past.

According to the present invention, there is always at least a plating clamp arranged on a first side of the galvanic plating device, which has the purpose of transporting each substrate to be treated through the entire galvanic plating device. Very often it is preferred to have a plurality of plating clamps for this purpose. Such plating clamp(s) are also providing the required electrical contact to each substrate to be treated.

In theory, one could think about to install also on the opposite side of the galvanic plating device at least a plating clamp or a series of plating clamps in order to stretch thin substrates to be treated to avoid damages by crumpling. However, it is not possible up to now to synchronize such a transport of individual substrates to be treated by plating clamps on both sides. There is also in such a case the problem that the electrolyte flow towards the surface of the substrate to be treated generates such high forces that plating clamps on both sides could work. Either the thin substrate to be treated would be getting ruptured if the clamping is strong enough on both sides, or the substrate to be treated would be loose the contact to at least one of both plating clamps on at least one side. Besides these technical hindrances, a second series of plating clamps would also generate tremendous additional cost and would further require much more constructed space, which is very often not available.

As used herein, the term "substrate guiding element" refers to an element, which is required, intended or supposed to support the transportation of a substrate to be treated through the galvanic plating device without that the substrate to be treated will be damaged by unintentional undesired movements.

Such inventive substrate guiding elements are arranged on the surface of the covering plate of the respective galvanic plating module, wherein said substrate guiding element is in conjunction with said surface of the covering plate of the galvanic plating module.

If galvanic plating modules are only arranged below the transport level of the substrates to be treated, a one side galvanic process is taking place, wherein said substrates are supposed to be transported by at least a plating clamp, which clamps the substrate to be treated on one side, on the surface of the electrolyte, which is inserted from below. In such a plating process, the substrates will receive a galvanic metal plating layer on the underside.

However, very often the substrates do not behave like this, which can be noticed by unintentional undesired movements downwards in the electrolyte. Then, the inventive substrate guiding elements serve the purpose to lead the substrates again upwards during their transportation through the galvanic plating device. Herein, said substrate guiding elements do not transport the substrate to be treated actively, such as rollers or wheel axis. They serve only the purpose that they shall support the transport of the substrates, wherein the flexible substrates are guided back to their ideal transportation pathway, which means in case of a one sided galvanic treatment back to the surface of the electrolyte bath level.

In a preferred embodiment for such a one side treatment, the distance between the upper surface of such a substrate guiding element and the lower surface of a substrate to be treated is minimized because the substrate to be treated is so heavy and/or so flexible that it will not remain on the surface of the electrolyte without permanent support from below. Then, the inventive substrate guiding elements provide a continuous support from below for the transportation of the substrates to be treated without that they actively transport said substrates. The substrate guiding elements guide only the substrates in such a way that the underside of the substrates is gliding over the upper surface of the substrate guiding elements during the transportation by the clamp(s) through the galvanic plating device. Conclusively, in such a preferred embodiment of the invention, the material of the substrate guiding elements have to be carefully chosen in order to avoid damages on the surface of the substrates to be treated and particle contamination caused by abrasion.

In some embodiments of the present invention, there can be inserted additional transport elements as assistance for the plating clamps, which are arranged and installed in the covering plate of the respective galvanic plating module, such as small wheels. But, on the other side, such additional transport elements would be arranged between the anode element(s) and the electrolyte nozzle(s) on the one side and the substrates to be treated on the other side. Thus, it would again hamper the electrical field and the electrolyte flow towards the surface of the substrates to be treated. Therefore it is preferred that the galvanic plating device is free of any additional transport element, such as wheel axis or rollers, for transporting the substrates to be treated in transport direction through the galvanic plating device except making use of at least a plating clamp.

In one embodiment, the galvanic plating device further comprises at least a second galvanic plating module, which is arranged above the transport level of a substrate to be treated; wherein said second galvanic plating module comprises at least an electrolyte nozzle and at least an anode element inside of said galvanic plating module, wherein said second galvanic plating module further comprises at least a covering plate arranged below the anode element and the electrolyte nozzle having a plurality of openings; wherein the galvanic plating device further comprises at least a substrate guiding element arranged on the surface of the covering plate of said second galvanic plating module, wherein said substrate guiding element is in conjunction with said surface of the covering plate of the second galvanic plating module.

Herein, galvanic plating modules are arranged below and above the transport level of the substrates to be treated leading to a two side galvanic process, wherein said substrates are still transported by at least a plating clamp, which clamps the substrate to be treated on one side, through the electrolyte, which is inserted from below and above at the same time. In such a plating process, the substrates will receive a galvanic metal plating layer on the underside and on the upper side simultaneously.

However, very often the substrates do not behave like this, which can be noticed by unintentional undesired movements inside of the electrolyte. It is the most efficient way, if the substrates to be treated are transported at a transport level, which corresponds to the so-called "zero line" of the anodes. Herein, the "zero line" means the middle of the distance between the lower anode surface of the anode element(s) above the transport level and the upper surface of the anode element(s) below the transport level of the substrate(s) to be treated.

Thus, in a preferred embodiment of the present invention, the substrate guiding element(s) of the respective galvanic plating module below the transport level of the substrates to be treated and the substrate guiding element(s) of the respective galvanic plating module above the transport level of the substrates to be treated support the transportation of the substrates to be treated between them along said aforementioned "zero line" through the galvanic plating device.

Also herein, said substrate guiding elements do not transport the substrate to be treated actively. They serve only the purpose that they shall support the transport of the substrates, wherein the flexible substrates are guided back to their ideal transportation pathway.

In a more preferred embodiment for such a two side treatment, the distance between the upper surface of such a substrate guiding element below the transport level and the lower surface of a substrate to be treated is minimized because the substrate to be treated is so heavy and/or so flexible that it will not remain on the so-called "zero line" inside of the electrolyte without permanent support from below. Then, the inventive substrate guiding elements of the respective galvanic plating module(s) being arranged below the transport level of the substrates to be treated provide a continuous support from below for the transportation of the substrates to be treated without that they actively transport said substrates. Said substrate guiding elements guide only the substrates in such a way that the underside of the substrates is gliding over the upper surface of said substrate guiding elements during the transportation by the clamp(s) through the galvanic plating device. Conclusively, in such a more preferred embodiment of the invention, the material of said substrate guiding elements have to be carefully chosen in order to avoid damages on the surface of the substrates to be treated and particle contamination caused by abrasion. In such a more preferred embodiment, there is still a certain distance between the upper surface of the substrates to be treated and the surface of the substrate guiding element(s) of the respective galvanic plating module(s) arranged above the transport level in order to allow some controlled deviation from the "zero line" of the substrate to be treated. This has been found to be necessary to be able to transport the substrates through the galvanic plating device at all. Ideally, one would choose also a minimal distance above the transport level in order to avoid any deviation from the "zero line". But this is in practice not possible. Substrate(s) to be treated can unfortunately not be processed in such a high accurate way.

A skilled person could also not simply avoid making use of the inventive substrate guiding element(s) by enlarging the covering plate of the respective galvanic plating module(s). Even when minimal distances between the surface(s) of the substrate(s) to be treated and the surface(s) of the covering plate(s) are reached so that the substrate(s) could be theoretically transported along the "zero line", the galvanic plating results are absolutely unsuitable for galvanic processes and customer demands due to a very high inhomogeneity of the electric field of the respective anode element(s) of the galvanic plating module(s).

In one embodiment, the substrate guiding elements of the first and/or of the second galvanic plating module are at least partially permanently fixed on the surface of the respective covering plate of the corresponding galvanic plating module.

In a preferred embodiment of the present invention, the substrate guiding elements of the first and/or of the second galvanic plating module are detachably connected with the surface of the respective covering plate of the corresponding galvanic plating module.

This offers the advantage that the substrate guiding element(s) can be easily replaced for maintenance reasons or for modifying an installed galvanic plating device for processing substrates to be treated of different thicknesses. It is particularly useful for processing substrates of different thicknesses along the "zero line" for a two side treatment. If the thickness of the substrates to be treated changes, the distances from the substrate guiding element(s) have also to be changed.

In one embodiment, the covering plate of the first and/or of the second galvanic plating module and their respective substrate guiding elements are made of a non-metallic material, preferably made of polymeric material, more preferably made of PTFE, PE and PP.

PTFE is especially preferred due to its relative softness, which helps avoiding possible damages of the substrates to be treated.

The substrate guiding element(s) have to be composed of non-metallic material to avoid undesired additional plating of the galvanic metal to be deposited on the surface of the substrate guiding element(s). A metal core for stiffening of the substrate guiding element(s) itself is possible, but only as long as there is ensured that no influence will be generated on the electrical field lines of the respective anode element(s) of the galvanic plating modules. At the same time substrate guiding element(s) should not cover electrolyte nozzle(s) or anode element(s).

In one embodiment, each substrate guiding element of the first and/or of the second galvanic plating module further comprise at least two plugs at their bottom side, which are fitting in respective recesses or holes in the respective covering plate of the corresponding galvanic plating module.

It can be made exchangeable or permanently fixed, such as by gluing.

In one embodiment, the covering plate of the first and/or of the second galvanic plating module further comprise for each substrate guiding element a respective recess, in which the substrate guiding element can be inserted custom-fit in a form-locking manner.

In a preferred embodiment thereof, the recesses of the first and/or of the second galvanic plating module allow the insertion of a substrate guiding element having a dove tail profile.

This offers the advantage that two different non-metallic materials, preferably polymeric materials, are possibly applicable for the covering plate and for the substrate guiding element in order to make use of different thermal expansion coefficients of both materials without that the detachably connected parts will be released.

In one embodiment, the first and/or the second galvanic plating module of the galvanic plating device comprises a plurality of linear substrate guiding elements, which are running parallel to each other in transport direction of the substrates to be treated inside of the respective galvanic plating module.

In a preferred alternative embodiment, the first and/or the second galvanic plating module of the galvanic plating device comprises a plurality of linear substrate guiding elements, which are running parallel to each other at a positive angle related to the transport direction of the substrates to be treated, wherein preferably said positive angle is the same for both galvanic plating modules.

This offers the additional advantage that the substrates to be treated are self-tightened by the flow of the electrolyte, if there is at least an outlet for the electrolyte on the opposite side of the first side of the galvanic plating module.

In one embodiment, the galvanic plating device further comprises at least a third galvanic plating module being arranged adjacent to the first galvanic plating module below a transport level of a substrate to be treated, wherein the first and the third galvanic plating module both comprise a plurality of linear substrate guiding elements, which are running parallel to each other at a positive angle related to the transport direction of the substrates to be treated inside of the respective galvanic plating module, wherein the positive angle in the first galvanic plating module is different to the positive angle in the third galvanic plating module.

In one embodiment, the galvanic plating device further comprises at least a third galvanic plating module being arranged adjacent to the first galvanic plating module below a transport level of a substrate to be treated; and further comprises at least a second and a fourth galvanic plating module being arranged adjacent to each other above a transport level of a substrate to be treated; wherein the first, second, third and fourth galvanic plating module each comprise a plurality of linear substrate guiding elements, which are running parallel to each other at a positive angle related to the transport direction of the substrates to be treated inside of the respective galvanic plating module, wherein preferably the positive angle in the first and second galvanic plating module is different from the positive angle in the third and fourth galvanic plating module.

In a preferred embodiment, the substrate guiding elements of the galvanic plating modules arranged above the transport level possess a straight flat edge. This allows a facilitated access of the user of the galvanic processing line to the respective upper galvanic plating modules above the transport level of said line facilitating doing maintenance, replacements and/or repairs.

In one embodiment, each substrate guiding element of a galvanic plating module below and/or above of the transport level of the substrates to be treated possess a chamfer in transport direction of the galvanic plating device.

This minimizes further the risk of damaging the substrates to be treated.

In a preferred embodiment, at least one substrate guiding element of a galvanic plating module below and/or above of the transport level of the substrates to be treated comprises at least one opening going from the upper side downward to the bottom side of the respective substrate guiding element.

This is advantageous for applications, which require a further reduction of the negative effect of the covering plate on the electrical field and the electrolyte flow. Besides providing a covering plate having a maximum of openings, in such a preferred embodiment for special applications, the substrate guiding element(s) itself/themselves provide(s) at least one opening inside of the substrate guiding element in order to further minimize the covering of the anode element and the electrolyte nozzle(s). Said advantage is increasing continuously the more substrate guiding elements without openings are substituted by substrate guiding elements having such an at least one opening.

It has been surprisingly found that the filling performance of such an inventive galvanic plating module comprising substrate guiding element(s) having such opening(s) is remarkable further improved, in particular for blind hole filling and X-plating of through silicon vias (TSV).

In a more preferred embodiment thereof, all substrate guiding elements of all galvanic plating modules below and/or above of the transport level of the substrates to be treated comprises at least one opening going from the upper side downward to the bottom side of the respective substrate guiding element.

The size and dimension of such an opening inside of the substrate guiding elements of these preferred embodiments of the invention can be freely chosen as long as the substrate guiding elements can still fulfill the object of the invention, namely to ensure a safe transportation of the substrates to be treated through the galvanic plating device. The respective openings can be exemplarily provided as a subsequently arranged plurality of circular openings providing thereby a plurality of through going conduits.

The invention is further related to the use of such an inventive galvanic plating device for galvanic metal, preferably copper, deposition on printed circuit foils, flexible printed circuit boards and embedded chip substrates.

As used herein, the term "entry side" refers to said side of the galvanic plating device of a horizontal process line, wherein a substrate to be treated will arrive in transport direction in the transportation area at the galvanic plating module before entering the galvanic plating module in which the substrate to be treated will run subsequently.

As used herein, the term "exit side" refers to said side of the galvanic plating device of a horizontal process line, wherein a substrate to be treated will arrive in transport direction in the transportation area at the galvanic plating module after leaving the galvanic plating module in which the substrate to be treated has been run before.

The present invention thus addresses the problem of transporting thin (down to 25 micrometers) and flexible substrates to be treated through a horizontal process line without damaging them. The flexible thin substrates to be treated cannot more flow upwards or downwards between individual transport elements being arranged below or above the transport level.

The following non-limiting examples are provided to illustrate an embodiment of the present invention and to facilitate understanding of the invention, but are not intended to limit the scope of the invention, which is defined by the claims appended hereto.

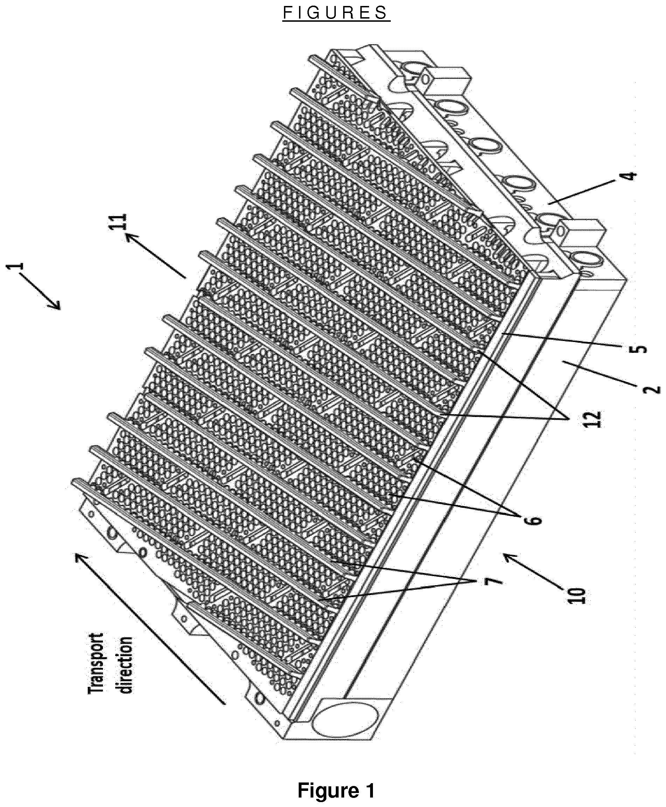

Turning now to the Figures, Figure 1 shows a schematic perspective side view of a galvanic plating device 1 of a horizontal galvanic plating processing line for galvanic metal, in particular copper, deposition in accordance with a preferred embodiment of the present invention.

Herein, said galvanic plating device 1 comprises a first galvanic plating module 2, which is arranged below a transport level of a substrate to be treated (not shown), and at least a plating clamp (not shown) arranged on a first side 4 of the galvanic plating device 1.

The first galvanic plating module 2 comprises a plurality of electrolyte nozzles and a plurality of anode elements inside of said galvanic plating module 2, wherein said galvanic plating module 2 further comprises a covering plate 5 having a plurality of openings 6 arranged above the anode element and the electrolyte nozzle.

The galvanic plating device 1 further comprises a first galvanic plating module 2 having a plurality of linear substrate guiding elements 7, which are running parallel to each other at a positive angle related to the transport direction of the substrates to be treated (not shown).

The plurality of a substrate guiding elements 7 are arranged on the surface of the covering plate 5 of the galvanic plating module 2, wherein said substrate guiding elements 7 are in conjunction with said surface of the covering plate 5 of the galvanic plating module 2, wherein the substrate guiding elements 7 are detachably connected with the surface of the respective covering plate 5.

The covering plate 5 of the first galvanic plating module 2 comprises for each substrate guiding element 7 a respective recess in which the substrate guiding element 7 can be inserted custom-fit in a form-locking manner. The recesses of the first galvanic plating module 2 allow herein the insertion of a substrate guiding element 7 having a dove tail profile. Said substrate guiding elements 7 possess herein a chamfer 12 in transport direction of the galvanic plating device 1. Said substrate guiding elements 7 and the respective covering plate 5 of the first galvanic plating module 2 are made of polymeric material, wherein the substrate guiding elements 7 are made of PTFE.

The galvanic plating device 1 shown is free of any additional transport element, such as wheel axis or rollers, for transporting the substrates to be treated (not shown) in transport direction through the galvanic plating device 1 except making use of at least a plating clamp (not shown).

The entry side 10 of the first galvanic plating module and the exit side 11 of the first galvanic plating module are illustrated.

On the first side of the galvanic plating device 1 the at least one plating clamp for contacting and transporting the respective substrate to be treated is not illustrated for facilitating the understanding of the invention. The anode elements in this particular embodiment of the invention are running straight.

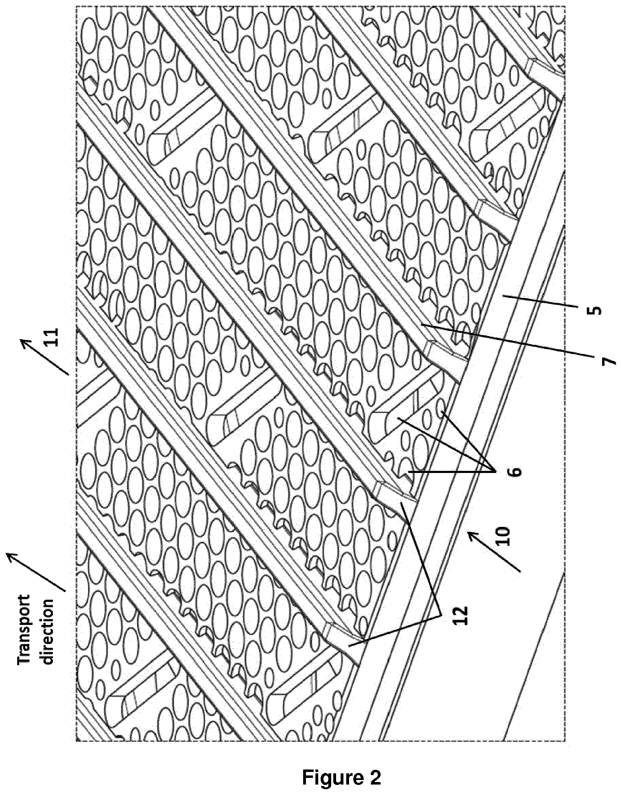

Figure 2 shows an enlarged schematic perspective side view on the entry side 10 of a first galvanic plating module 2 of an inventive galvanic plating device 1 in accordance with the embodiment of the present invention shown in Figure 1.

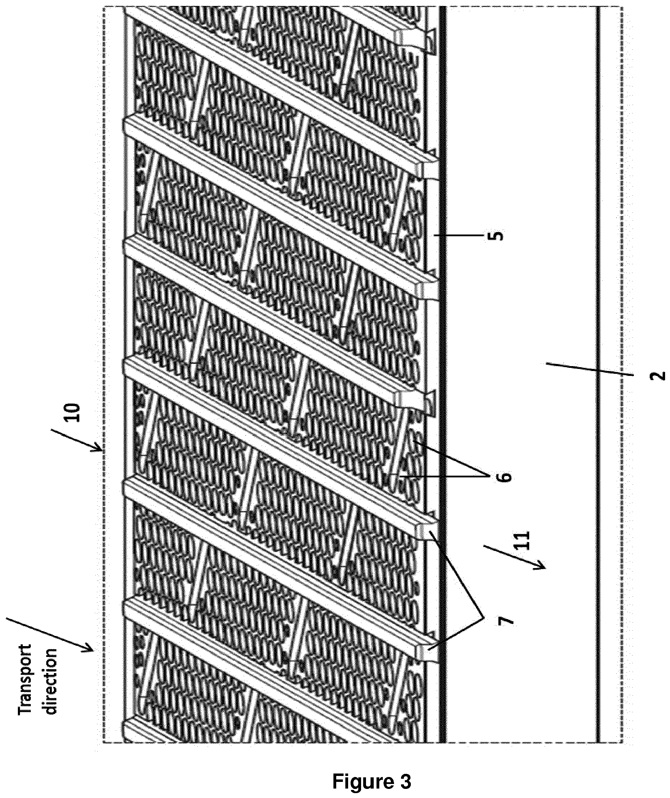

Figure 3 shows an enlarged schematic perspective side view on the exit side 11 of a first galvanic plating module 2 of an inventive galvanic plating device 1 in accordance with the embodiment of the present invention shown in Figure 1.

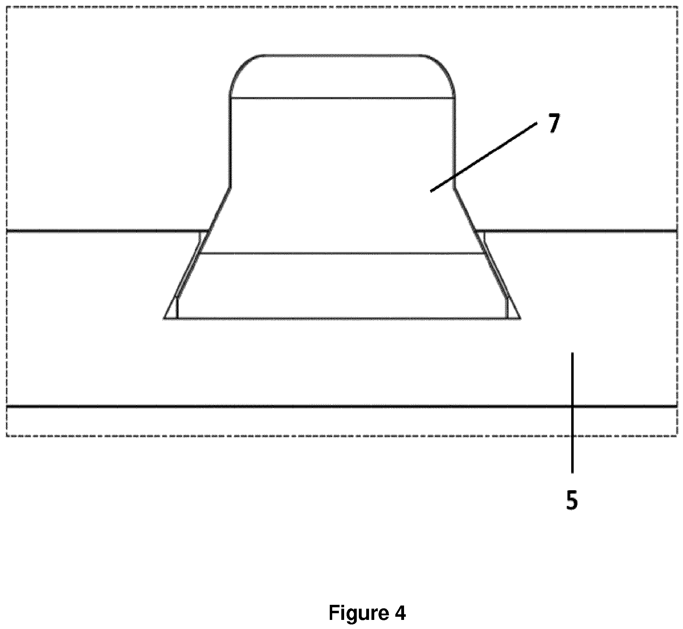

Figure 4 shows a schematic front view of an individual substrate guiding element 7 having a dove tail profile being used in a first galvanic plating module 2 of an inventive galvanic plating device 1 in accordance with the embodiment of the present invention shown in Figure 1.

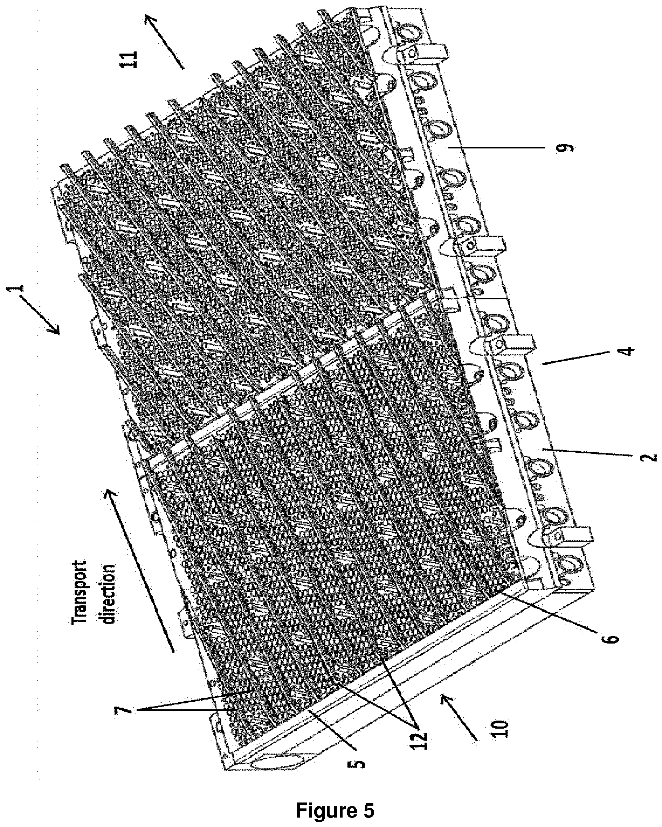

Figure 5 shows a schematic perspective side view of a first 2 and an adjacent third 9 galvanic plating module of an inventive galvanic plating device 1 in accordance with the embodiment of the present invention shown in Figure 1.

Herein, it is additionally shown that the galvanic plating device 1 further comprises a third galvanic plating module 9 being arranged adjacent to the first galvanic plating module 2 below a transport level of a substrate to be treated (not shown), wherein the first 2 and the third 9 galvanic plating module both comprise a plurality of linear substrate guiding elements 7, which are running parallel to each other at a positive angle related to the transport direction of the substrates to be treated (not shown) inside of the respective galvanic plating module 2, 9, wherein the positive angle in the first galvanic plating module 2 is different to the positive angle in the third galvanic plating module 9.

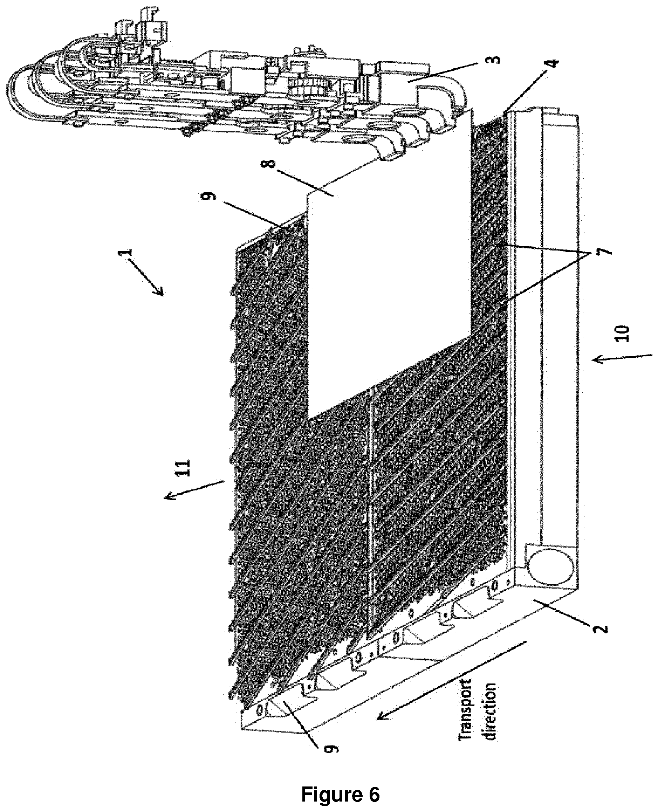

Figure 6 shows a schematic perspective front view of a first 2 and an adjacent third 9 galvanic plating module of an inventive galvanic plating device 1 in accordance with the embodiment of the present invention shown in Figure 1.

Herein, it is additionally illustrated three plating clamps 3 on the first side 4 of the first galvanic plating module 2, which clamp a substrate to be treated 8.

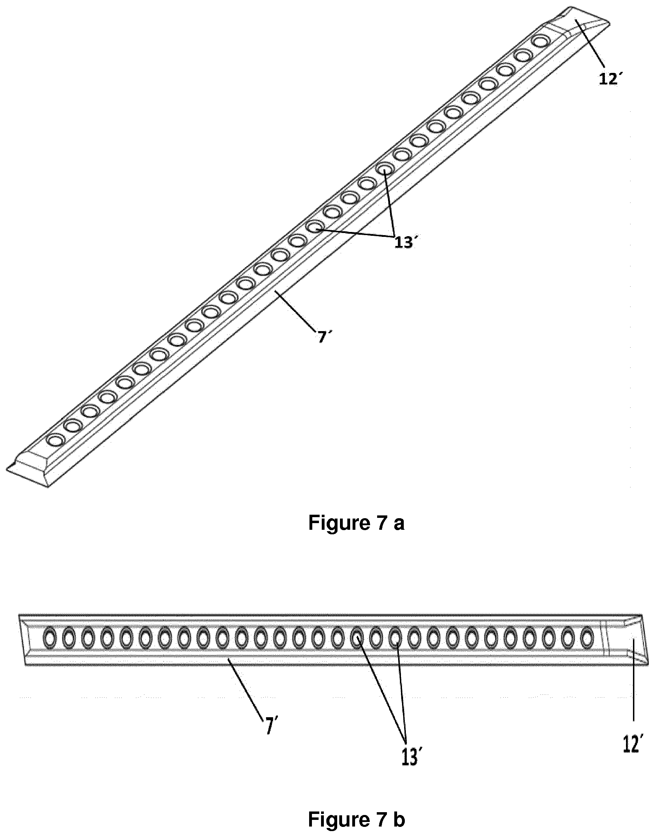

Figure 7a shows a schematic perspective side view of a substrate guiding element 7' used in a preferred embodiment of the present invention. Herein, an exemplarily substrate guiding element 7' of a galvanic plating device is shown, which comprises a plurality of circular openings 13' in the substrate guiding element 7' going from the upper side downward to the bottom side of the substrate guiding element 7'. As can be easily seen in Figure 7a, the substrate guiding element 7' has a chamfer 12' at the one end. The plurality of openings 13' in the substrate guiding element is provided in form of through going conduits having a constant diameter.

This preferred embodiment exhibits one possibility of providing a modified substrate guiding element 7' having at least one opening 13' without that the substrate guiding element 7' becomes unsuitable to still solve the object of the invention, namely to ensure a safe transportation of the substrates to be treated through the galvanic plating device.

Such a plurality of openings 13' is preferred in comparison to one single opening 13' running through the entire substrate guiding element 7' due to stability reasons, if the size and dimension of the substrate guiding element 7' itself is intended to remain unchanged.

Figure 7b shows a schematic top view of a substrate guiding element used in the preferred embodiment of the present invention shown in Figure 7a.

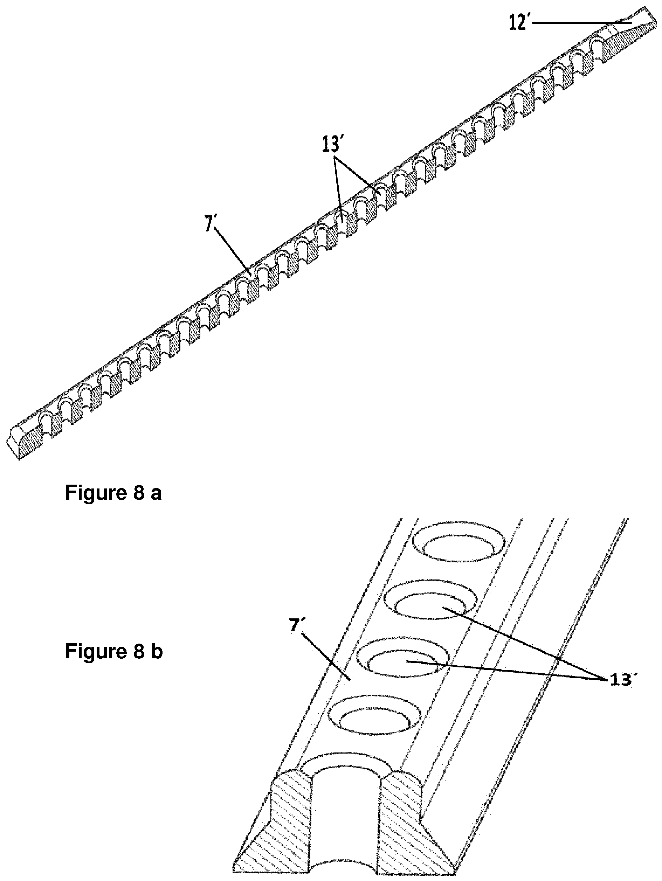

Figure 8a shows a schematic perspective sectional side view of a substrate guiding element used in the preferred embodiment of the present invention shown in Figure 7a.

Figure 8b shows another schematic perspective sectional side view of a substrate guiding element used in the preferred embodiment of the present invention shown in Figure 7a.

Both Figures 8a and 8b show in a clear manner that the plurality of openings 13' in the substrate guiding element 7' are provided in form of through going conduits having a constant diameter.

While the principles of the invention have been explained in relation to certain particular embodiments, and are provided for purposes of illustration, it is to be understood that various modifications thereof will become apparent to those skilled in the art upon reading the specification. Therefore, it is to be understood that the invention disclosed herein is intended to cover such modifications as fall within the scope of the appended claims. The scope of the invention is limited only by the scope of the appended claims.

### Reference signs

- 1: Galvanic plating device
- 2: First galvanic plating module
- 3: Plating clamp
- 4: First side of the first galvanic plating module
- 5: Covering plate of the first galvanic plating module
- 6: Openings in the covering plate of the first galvanic plating module
- 7, 7': Substrate guiding element
- 8: Substrate to be treated
- 9: Third galvanic plating module
- 10: Entry side of the first galvanic plating module
- 11: Exit side of the first galvanic plating module
- 12, 12': Chamfer of the substrate guiding element
- 13': Openings in the substrate guiding element 7'

## Claims

1. Galvanic plating device (1) of a horizontal galvanic plating processing line for galvanic metal, in particular copper, deposition;
wherein said galvanic plating device (1) comprises at least a first galvanic plating module (2), which is arranged below a transport level of a substrate to be treated (8), and at least a plating clamp (3) arranged on a first side (4) of the galvanic plating device (1);
wherein said first galvanic plating module (2) comprises at least an electrolyte nozzle and at least an anode element inside of said galvanic plating module (2), **characterized in that**
said galvanic plating module (2) further comprises at least a covering plate (5) having a plurality of openings (6) arranged above the anode element and the electrolyte nozzle, and
wherein the galvanic plating device (1) further comprises at least a substrate guiding element (7,7') arranged on the surface of the covering plate (5) of the galvanic plating module (2), wherein said substrate guiding element (7, 7') is in conjunction with said surface of the covering plate (5) of the galvanic plating module (2).

2. Galvanic plating device according to claim 1 **characterized in that** the galvanic plating device (1) further comprises at least a second galvanic plating module, which is arranged above the transport level of a substrate to be treated (8); wherein said second galvanic plating module comprises at least an electrolyte nozzle and at least an anode element inside of said galvanic plating module, wherein said second galvanic plating module further comprises at least a covering plate arranged below the anode element and the electrolyte nozzle having a plurality of openings; wherein the galvanic plating device (1) further comprises at least a substrate guiding element arranged on the surface of the covering plate of said second galvanic plating module, wherein said substrate guiding element is in conjunction with said surface of the covering plate of the second galvanic plating module.

3. Galvanic plating device according to claim 1 or 2 **characterized in that** the substrate guiding elements (7, 7') of the first (2) and/or of the second galvanic plating module are at least partially permanently fixed on the surface of the respective covering plate (5) of the corresponding galvanic plating module.

4. Galvanic plating device according to claim 1 or 2 **characterized in that** the substrate guiding elements (7, 7') of the first (2) and/or of the second galvanic plating module are detachably connected with the surface of the respective covering plate (5) of the corresponding galvanic plating module.

5. Galvanic plating device according to one of the preceding claims **characterized in that** each substrate guiding element (7, 7') of the first (2) and/or of the second galvanic plating module further comprise at least two plugs at their bottom side, which are fitting in respective recesses or holes in the respective covering plate (5) of the corresponding galvanic plating module.

6. Galvanic plating device according to one of the preceding claims **characterized in that** the covering plate (5) of the first (2) and/or of the second galvanic plating module further comprise for each substrate guiding element (7, 7') a respective recess in which the substrate guiding element (7, 7') can be inserted custom-fit in a form-locking manner.

7. Galvanic plating device according to claim 6 **characterized in that** the recesses of the first (2) and/or of the second galvanic plating module allow the insertion of a substrate guiding element (7, 7') having a dove tail profile.

8. Galvanic plating device according to one of the preceding claims **characterized in that** the covering plate (5) of the first (2) and/or of the second galvanic plating module and their respective substrate guiding elements (7, 7') are made of a non-metallic material, preferably made of polymeric material, more preferably made of PTFE, PE and PP.

9. Galvanic plating device according to one of the preceding claims **characterized in that** the first (2) and/or the second galvanic plating module of the galvanic plating device (1) comprises a plurality of linear substrate guiding elements (7, 7'), which are running parallel to each other in transport direction of the substrates to be treated (8) inside of the respective galvanic plating module.

10. Galvanic plating device according to one of the preceding claims **characterized in that** the first (2) and/or the second galvanic plating module of the galvanic plating device (1) comprises a plurality of linear substrate guiding elements (7, 7'), which are running parallel to each other at a positive angle related to the transport direction of the substrates to be treated (8), wherein preferably said positive angle is the same for both galvanic plating modules.

11. Galvanic plating device according to one of the preceding claims **characterized in that** the galvanic plating device (1) further comprises at least a third galvanic plating module (9) being arranged adjacent to the first galvanic plating module (2) below a transport level of a substrate to be treated (8), wherein the first (2) and the third (9) galvanic plating module both comprise a plurality of linear substrate guiding elements (7, 7'), which are running parallel to each other at a positive angle related to the transport direction of the substrates to be treated (8) inside of the respective galvanic plating module (2, 9), wherein the positive angle in the first galvanic plating module (2) is different to the positive angle in the third galvanic plating module (9).

12. Galvanic plating device according to one of the preceding claims **characterized in that** the galvanic plating device (1) further comprises at least a third galvanic plating module (9) being arranged adjacent to the first galvanic plating module (2) below a transport level of a substrate to be treated (8); and further comprises at least a second and a fourth galvanic plating module being arranged adjacent to each other above a transport level of a substrate to be treated (8); wherein the first (2), second, third (9) and fourth galvanic plating module each comprise a plurality of linear substrate guiding elements (7, 7'), which are running parallel to each other at a positive angle related to the transport direction of the substrates to be treated (8) inside of the respective galvanic plating module, wherein preferably the positive angle in the first (2) and second galvanic plating module is different from the positive angle in the third (9) and fourth galvanic plating module.

13. Galvanic plating device according to one of the preceding claims **characterized in that** each substrate guiding element (7, 7') of a galvanic plating module below and/or above of the transport level of the substrates to be treated (8) possess a chamfer (12, 12') in transport direction of the galvanic plating device (1).

14. Galvanic plating device according to one of the preceding claims **characterized in that** the galvanic plating device (1) is free of any additional transport element, such as wheel axis or rollers, for transporting the substrates to be treated (8) in transport direction through the galvanic plating device (1) except making use of at least a plating clamp (3).

15. Use of a galvanic plating device (1) according to one of claims 1 to 14 for galvanic metal, preferably copper, deposition on printed circuit foils, flexible printed circuit boards and embedded chip substrates.

## Patentansprüche

1. Galvanische Plattierungsvorrichtung (1) einer horizontalen galvanischen Plattierungsprozesslinie zur galvanischen Abscheidung von Metall, insbesondere Kupfer;
wobei die galvanische Plattierungsvorrichtung (1) mindestens ein erstes galvanisches Plattierungsmodul (2), das unterhalb einer Transportebene eines zu behandelnden Substrats (8) angeordnet ist, und mindestens eine Plattierungsklammer (3), die an einer ersten Seite (4) der galvanischen Plattierungsvorrichtung (1) angeordnet ist, umfasst;
wobei das erste galvanische Plattierungsmodul (2) mindestens eine Elektrolytdüse und mindestens ein Anodenelement innerhalb dieses galvanischen Plattierungsmoduls (2) umfasst, **dadurch gekennzeichnet, dass**
dieses galvanische Plattierungsmodul (2) ferner mindestens eine Abdeckplatte (5) umfasst, die eine Mehrzahl von Öffnungen (6) aufweist, welche oberhalb des Anodenelements und der Elektrolytdüse angeordnet sind, und
wobei die galvanische Plattierungsvorrichtung (1) ferner mindestens ein Substratführungselement (7, 7') umfasst, das an der Oberfläche der Abdeckplatte (5) des galvanisches Plattierungsmoduls (2) angeordnet ist, wobei dieses Substratführungselement (7, 7') mit der Oberfläche der Abdeckplatte (5) des galvanischen Plattierungsmoduls (2) verbunden ist.

2. Galvanische Plattierungsvorrichtung nach Anspruch 1, **dadurch gekennzeichnet, dass** die galvanische Plattierungsvorrichtung (1) ferner mindestens ein zweites galvanisches Plattierungsmodul umfasst, das oberhalb der Transportebene eines zu behandelnden Substrats (8) angeordnet ist; wobei das zweite galvanische Plattierungsmodul mindestens eine Elektrolytdüse und mindestens ein Anodenelement innerhalb des galvanischen Plattierungsmoduls umfasst, wobei das zweite galvanische Plattierungsmodul ferner mindestens eine unterhalb des Anodenelements und der Elektrolytdüse angeordnete Abdeckplatte umfasst, die eine Mehrzahl von Öffnungen aufweist; wobei die galvanische Plattierungsvorrichtung (1) ferner mindestens ein Substratführungselement umfasst, das an der Oberfläche der Abdeckplatte des zweiten galvanischen Plattierungsmoduls angeordnet ist, wobei das Substratführungselement mit der Oberfläche der Abdeckplatte des zweiten galvanischen Plattierungsmoduls verbunden ist.

3. Galvanische Plattierungsvorrichtung nach Anspruch 1 oder 2, **dadurch gekennzeichnet, dass** die Substratführungselemente (7, 7') des ersten (2) und/oder des zweiten galvanischen Plattierungsmoduls zumindest teilweise dauerhaft an der Oberfläche der jeweiligen Abdeckplatte (5) des betreffenden galvanischen Plattierungsmoduls befestigt sind.

4. Galvanische Plattierungsvorrichtung nach Anspruch 1 oder 2, **dadurch gekennzeichnet, dass** die Substratführungselemente (7, 7') des ersten (2) und/oder des zweiten galvanischen Plattierungsmoduls lösbar mit der Oberfläche der jeweiligen Abdeckplatte (5) des betreffenden galvanischen Plattierungsmoduls verbunden sind.

5. Galvanische Plattierungsvorrichtung nach einem der vorstehenden Ansprüche, **dadurch gekennzeichnet, dass** jedes Substratführungselement (7, 7') des ersten (2) und/oder des zweiten galvanischen Plattierungsmoduls ferner mindestens zwei Stopfen an ihrer Unterseite aufweist, welche in entsprechende Aussparungen oder Löcher in der jeweiligen Abdeckplatte (5) des betreffenden galvanischen Plattierungsmoduls passen.

6. Galvanische Plattierungsvorrichtung nach einem der vorstehenden Ansprüche, **dadurch gekennzeichnet, dass** die Abdeckplatte (5) des ersten (2) und/oder des zweiten galvanischen Plattierungsmoduls ferner für jedes Substratführungselement (7, 7') eine entsprechende Aussparung aufweist, in welche das Substratführungselement (7, 7') passgenau formschlüssig eingesetzt werden kann.

7. Galvanische Plattierungsvorrichtung nach Anspruch 6, **dadurch gekennzeichnet, dass** die Aussparungen des ersten (2) und/oder des zweiten galvanischen Plattierungsmoduls das Einsetzen eines Substratführungselements (7, 7'), das ein Schwalbenschwanzprofil aufweist, ermöglichen.

8. Galvanische Plattierungsvorrichtung nach einem der vorstehenden Ansprüche, **dadurch gekennzeichnet, dass** die Abdeckplatte (5) des ersten (2) und/oder des zweiten galvanischen Plattierungsmodulsund deren jeweilige Substratführungselemente (7, 7') aus einem nichtmetallischen Werkstoff, vorzugsweise aus einem Polymerwerkstoff, bevorzugter aus PTFE, PE und PP, gefertigt sind.

9. Galvanische Plattierungsvorrichtung nach einem der vorstehenden Ansprüche, **dadurch gekennzeichnet, dass** das erste (2) und/oder das zweite galvanische Plattierungsmodul der galvanischen Plattierungsvorrichtung (1) eine Mehrzahl von linearen Substratführungselementen (7, 7') umfasst, die in Transportrichtung der zu behandelnden Substrate (8) innerhalb des jeweiligen galvanischen Plattierungsmoduls parallel zueinander verlaufen.

10. Galvanische Plattierungsvorrichtung nach einem der vorstehenden Ansprüche, **dadurch gekennzeichnet, dass** das erste (2) und/oder das zweite galvanische Plattierungsmodul der galvanischen Plattierungsvorrichtung (1) eine Mehrzahl von linearen Substratführungselementen (7, 7') umfasst, die in einem positiven Winkel in Bezug auf die Transportrichtung der zu behandelnden Substrate (8) parallel zueinander verlaufen, wobei der positive Winkel vorzugsweise für beide galvanischen Plattierungsmodule derselbe ist.

11. Galvanische Plattierungsvorrichtung nach einem der vorstehenden Ansprüche, **dadurch gekennzeichnet, dass** die galvanische Plattierungsvorrichtung (1) ferner mindestens ein drittes galvanisches Plattierungsmodul (9) umfasst, das neben dem ersten galvanischen Plattierungsmodul (2) unterhalb einer Transportebene eines zu behandelnden Substrats (8) angeordnet ist, wobei das erste (2) und das dritte (9) galvanische Plattierungsmodul jeweils eine Mehrzahl von linearen Substratführungselementen (7, 7') umfassen, die in einem positiven Winkel in Bezug auf die Transportrichtung der zu behandelnden Substrate (8) innerhalb des jeweiligen galvanischen Plattierungsmoduls (2, 9) parallel zueinander verlaufen, wobei sich der positive Winkel im ersten galvanischen Plattierungsmodul (2) vom positiven Winkel im dritten galvanischen Plattierungsmodul (9) unterscheidet.

12. Galvanische Plattierungsvorrichtung nach einem der vorstehenden Ansprüche, **dadurch gekennzeichnet, dass** die galvanische Plattierungsvorrichtung (1) ferner mindestens ein drittes galvanisches Plattierungsmodul (9) umfasst, das neben dem ersten galvanischen Plattierungsmodul (2) unterhalb einer Transportebene eines zu behandelnden Substrats (8) angeordnet ist; und ferner mindestens ein zweites und ein viertes galvanisches Plattierungsmodulumfasst, die nebeneinander oberhalb einer Transportebene eines zu behandelnden Substrats (8) angeordnet sind; wobei das erste (2), zweite, dritte (9) und vierte galvanische Plattierungsmodul jeweils eine Mehrzahl von linearen Substratführungselementen (7, 7') umfassen, die in einem positiven Winkel in Bezug auf die Transportrichtung der zu behandelnden Substrate (8) innerhalb des jeweiligen galvanischen Plattierungsmoduls parallel zueinander verlaufen, wobei sich der positive Winkel im ersten (2) und im zweiten galvanischen Plattierungsmodul vorzugsweise vom positiven Winkel im dritten (9) und im vierten galvanischen Plattierungsmodul unterscheidet.

13. Galvanische Plattierungsvorrichtung nach einem der vorstehenden Ansprüche, **dadurch gekennzeichnet, dass** jedes Substratführungselement (7, 7') eines galvanischen Plattierungsmoduls unterhalb und/oder oberhalb der Transportebene der zu behandelnden Substrate (8) eine Abschrägung (12, 12') in Transportrichtung der galvanischen Plattierungsvorrichtung (1) aufweist.

14. Galvanische Plattierungsvorrichtung nach einem der vorstehenden Ansprüche, **dadurch gekennzeichnet, dass** die galvanische Plattierungsvorrichtung (1) abgesehen von der Verwendung mindestens einer Plattierungsklammer (3) keinerlei zusätzlichen Transportelemente, wie zum Beispiel Radachsen oder Rollen/Walzen, für den Transport der zu behandelnden Substrate (8) in Transportrichtung durch die galvanische Plattierungsvorrichtung (1) aufweisen.

15. Verwendung einer galvanischen Plattierungsvorrichtung (1) nach einem der Ansprüche 1 bis 14 zur galvanischen Abscheidung von Metall, vorzugsweise Kupfer, auf gedruckten Schaltkreisfolien, flexiblen Leiterplatten und integrierten Chipsubstraten.

## Revendications

1. Dispositif de placage galvanique (1) d'une ligne de traitement de placage galvanique horizontale pour le dépôt de métal, en particulier de cuivre ;
ledit dispositif de placage galvanique (1) comprenant au moins un premier module de placage galvanique (2), qui est disposé au-dessous d'un niveau de transport d'un substrat à traiter (8), et au moins une pince de placage (3) disposée sur un premier côté (4) du dispositif de placage galvanique (1) ;
ledit premier module de placage galvanique (2) comprenant au moins une buse d'électrolyte et au moins un élément anodique à l'intérieur dudit module de placage galvanique (2), **caractérisé en ce que**
ledit module de placage galvanique (2) comprend en outre au moins une plaque de recouvrement (5) ayant une pluralité d'ouvertures (6) disposée au-dessus de l'élément anodique et de la buse d'électrolyte, et
le dispositif de placage galvanique (1) comprenant en outre au moins un élément de guidage de substrat (7, 7') disposé sur la surface de la plaque de recouvrement (5) du module de placage galvanique (2), ledit élément de guidage de substrat (7, 7') étant associé à ladite surface de la plaque de recouvrement (5) du module de placage galvanique (2).

2. Dispositif de placage galvanique selon la revendication 1 **caractérisé en ce que** le dispositif de placage galvanique (1) comprend en outre au moins un deuxième module de placage galvanique, qui est disposé au-dessus du niveau de transport d'un substrat à traiter (8) ; ledit deuxième module de placage galvanique comprenant au moins une buse d'électrolyte et au moins un élément anodique à l'intérieur dudit module de placage galvanique, ledit deuxième module de placage galvanique comprenant en outre au moins une plaque de recouvrement disposée au-dessous de l'élément anodique et de la buse d'électrolyte ayant une pluralité d'ouvertures ; le dispositif de placage galvanique (1) comprenant en outre au moins un élément de guidage de substrat disposé sur la surface de la plaque de recouvrement dudit deuxième module de placage galvanique, ledit élément de guidage de substrat étant associé à ladite surface de la plaque de recouvrement du deuxième module de placage galvanique.

3. Dispositif de placage galvanique selon la revendication 1 ou 2 **caractérisé en ce que** les éléments de guidage de substrat (7, 7') du premier (2) et/ou du deuxième module de placage galvanique sont fixés de façon au moins partiellement permanente sur la surface de la plaque de recouvrement respective (5) du module de placage galvanique correspondant.

4. Dispositif de placage galvanique selon la revendication 1 ou 2 **caractérisé en ce que** les éléments de guidage de substrat (7, 7') du premier (2) et/ou du deuxième module de placage galvanique sont raccordés de façon détachable à la surface de la plaque de recouvrement respective (5) du module de placage galvanique correspondant.

5. Dispositif de placage galvanique selon une des revendications précédentes **caractérisé en ce que** chaque élément de guidage de substrat (7, 7') du premier (2) et/ou du deuxième module de placage galvanique comprend en outre au moins deux fiches sur leur côté inférieur, qui s'installent dans des encoches ou trous respectifs dans la plaque de recouvrement respective (5) du module de placage galvanique correspondant.

6. Dispositif de placage galvanique selon une des revendications précédentes **caractérisé en ce que** la plaque de recouvrement (5) du premier (2) et/ou du deuxième module de placage galvanique comprend en outre pour chaque élément de guidage de substrat (7, 7') une encoche respective dans laquelle l'élément de guidage de substrat (7, 7') peut être inséré avec un ajustement sur mesure à la manière d'un assemblage par complémentarité de forme.

7. Dispositif de placage galvanique selon la revendication 6 **caractérisé en ce que** les encoches du premier (2) et/ou du deuxième module de placage galvanique permettent l'insertion d'un élément de guidage de substrat (7, 7') ayant un profil en queue d'aronde.

8. Dispositif de placage galvanique selon une des revendications précédentes **caractérisé en ce que** la plaque de recouvrement (5) du premier (2) et/ou du deuxième module de placage galvanique et leurs éléments de guidage de substrat respectifs (7, 7') sont constitués d'un matériau non métallique, de préférence constitués d'un matériau polymère, mieux encore constitués de PTFE, PE et PP.

9. Dispositif de placage galvanique selon une des revendications précédentes **caractérisé en ce que** le premier (2) et/ou le deuxième module de placage galvanique du dispositif de placage galvanique (1) comprend une pluralité d'éléments de guidage de substrat linéaires (7, 7'), qui courent parallèlement les uns aux autres dans une direction de transport des substrats à traiter (8) à l'intérieur du module de placage galvanique respectif.

10. Dispositif de placage galvanique selon une des revendications précédentes **caractérisé en ce que** le premier (2) et/ou le deuxième module de placage galvanique du dispositif de placage galvanique (1) comprennent une pluralité d'éléments de guidage de substrat linéaires (7, 7'), qui courent parallèlement les uns aux autres à un angle positif par rapport à la direction de transport des substrats à traiter (8), ledit angle positif étant de préférence le même pour les deux modules de placage galvanique.

11. Dispositif de placage galvanique selon une des revendications précédentes **caractérisé en ce que** le dispositif de placage galvanique (1) comprend en outre au moins un troisième module de placage galvanique (9) qui est disposé au voisinage du premier module de placage galvanique (2) au-dessous d'un niveau de transport d'un substrat à traiter (8), le premier (2) et le troisième (9) module de placage galvanique comprenant tous deux une pluralité d'éléments de guidage de substrat linéaires (7, 7'), qui courent parallèlement les uns aux autres à un angle positif par rapport à la direction de transport des substrats à traiter (8) à l'intérieur du module de placage galvanique respectif (2, 9), l'angle positif dans le premier module de placage galvanique (2) étant différent de l'angle positif dans le troisième module de placage galvanique (9).

12. Dispositif de placage galvanique selon une des revendications précédentes **caractérisé en ce que** le dispositif de placage galvanique (1) comprend en outre au moins un troisième module de placage galvanique (9) qui est disposé au voisinage du premier module de placage galvanique (2) au-dessous d'un niveau de transport d'un substrat à traiter (8) ; et comprend en outre au moins un deuxième et un quatrième module de placage galvanique qui sont disposés au voisinage l'un de l'autre au-dessus d'un niveau de transport d'un substrat à traiter (8) ; le premier (2), le deuxième, le troisième (9) et le quatrième module de placage galvanique comprenant chacun une pluralité d'éléments de guidage de substrat linéaires (7, 7'), qui courent parallèlement les uns aux autres à un angle positif par rapport à la direction de transport des substrats à traiter (8) à l'intérieur du module de placage galvanique respectif, l'angle positif dans le premier (2) et le deuxième module de placage galvanique étant de préférence différent de l'angle positif dans le troisième (9) et le quatrième module de placage galvanique.

13. Dispositif de placage galvanique selon une des revendications précédentes **caractérisé en ce que** chaque élément de guidage de substrat (7, 7') d'un module de placage galvanique au-dessous et/ou au-dessus du niveau de transport des substrats à traiter (8) possède un chanfrein (12, 12') dans une direction de transport du dispositif de placage galvanique (1).

14. Dispositif de placage galvanique selon une des revendications précédentes **caractérisé en ce que** le dispositif de placage galvanique (1) est dépourvu de tout élément de transport supplémentaire, tel qu'un axe de roue ou des rouleaux, pour transporter les substrats à traiter (8) dans une direction de transport à travers le dispositif de placage galvanique (1) à l'exception de l'utilisation d'au moins une pince de placage (3).

15. Utilisation d'un dispositif de placage galvanique (1) selon une des revendications 1 à 14 pour le dépôt galvanique de métal, de préférence de cuivre, sur des feuilles de circuits imprimés, des cartes de circuits imprimés souples et des substrats à puce intégrée.
